# EUROPEAN PATENT SPECIFICATION

(11) **EP 4 375 686 B1**
(45) Date of publication and mention of the grant of the patent: **06.08.2025**
(21) Application number: 23211402.5
(22) Date of filing: 22.11.2023
(51) Int. Cl.: G01R 31/382, G01R 31/3842, G01R 31/396

(54) **METHOD AND SYSTEM FOR DETERMINING STATE OF CHARGE, AND BATTERY SYSTEM**
VERFAHREN UND SYSTEM ZUR BESTIMMUNG DES LADEZUSTANDS UND BATTERIESYSTEM
PROCÉDÉ ET SYSTÈME DE DÉTERMINATION D'ÉTAT DE CHARGE, ET SYSTÈME DE BATTERIE

(30) Priority: 28.11.2022 KR 20220161766
(43) Date of publication of application: 29.05.2024
(73) Proprietor: Samsung SDI Co., Ltd., Yongin-si, Gyeonggi-do 17084 (KR)
(72) Inventor: Ha, Sangmin, Yongin-si, Gyeonggi-do 17084 (KR)
(74) Representative: Gulde & Partner

(56) References cited:
- ZHANG SHUZHI ET AL: "A novel low-complexity state-of-energy estimation method for series-connected lithium-ion battery pack based on "representative cell" selection and operating mode division", JOURNAL OF POWER SOURCES, ELSEVIER, AMSTERDAM, NL, vol. 518, 11 November 2021 (2021-11-11), XP086881214, ISSN: 0378-7753, [retrieved on 20211111], DOI: 10.1016/J.JPOWSOUR.2021.230732
- JIANG BO ET AL: "A Cell-to-Pack State Estimation Extension Method Based on a Multilayer Difference Model for Series-Connected Battery Packs", IEEE TRANSACTIONS ON TRANSPORTATION ELECTRIFICATION, IEEE, vol. 8, no. 2, 24 September 2021 (2021-09-24), pages 2037 - 2049, XP011906428, DOI: 10.1109/TTE.2021.3115597
- LI XIAOYU ET AL: "State of energy estimation for a series-connected lithium-ion battery pack based on an adaptive weighted strategy", ENERGY, ELSEVIER, AMSTERDAM, NL, vol. 214, 16 September 2020 (2020-09-16), XP086376969, ISSN: 0360-5442, [retrieved on 20200916], DOI: 10.1016/J.ENERGY.2020.118858

## Description

### BACKGROUND OF THE INVENTION

### (a) Field of the Invention

The present invention relates to a method for determining a state of charge, a system for determining a state of charge performing the same, and a battery system.

### (b) Description of the Related Art

An energy storage system (ESS) is a system that increases energy use efficiency by storing a large amount of electrical energy and supplying the stored electrical energy when electrical energy is needed. ESS may include a battery system, a battery management system (BMS) configured to manage the battery system, e.g., by monitoring voltage, current, temperature, and the like of the battery system, a power conversion system (PCS) configured to perform AC-DC conversion and distribution function, and an energy management system (EMS) configured to control an entire system of the ESS, e.g., by collecting and managing information on the state of the ESS as well as controlling energy flow of the ESS, and the like.

Typically, a battery system of the ESS includes a plurality of battery racks electrically interconnected to each other, and each battery rack may include dozens to hundreds of serially connected cells. Cells constituting one battery rack have differences in deterioration degree and characteristics due to differences in manufacturing processes or operating environments (e.g., temperature, etc.). When calculating the state of charge (SOC) for all cells constituting the battery rack in order to consider differences in the degree of deterioration and the characteristics, large-capacity memory and fast calculation speed are required, which may not be easily applicable to embedded systems. To solve this problem, a method of calculating SOC using the average voltage of all cells constituting one battery rack as a representative value has been proposed. However, when SOC is calculated using the average voltage as a representative value, an error with the actual available capacity of the battery rack may occur, resulting in over-charging when fully charged and over-discharging when fully discharging.

Shuzhi Zhang et al. (Journal of Power Sources vol. 518 (2021-11-11) presents a low-complexity state-of-energy estimation method for series-connected lithium-ion battery pack based on "representative cell" selection and operating mode division. The cell with the highest or lowest voltage or the least and most aged cell is chosen as the representative cell.

Bo Jiang et al. (IEEE Transactions on Transportation Electrification vol. 8, no. 2, 24 September 2021 (2021-09-24), pages 2037-2049, relates to a cell-to-pack state estimation extension method based on a multilayer difference model for series-connected battery packs. Xiaoyu Li et al. (Energy vol. 214, 16 September 2020 (2020-09-16) discusses a state of energy estimation method for a series-connected lithium-ion battery pack based on an adaptive weighted strategy on representative cells.

### SUMMARY OF THE INVENTION

The present invention attempts to provide a method for determining a state of charge, a system for determining a state of charge performing the same, and a battery system capable of protecting a battery system from dangerous situations such as over-charge and over-discharge while decreasing the amount of calculation for calculating the SOC.

A method for determining a state of charge of a battery system includes calculating a voltage difference between a first voltage detected at a first time point and a second voltage detected at a second time point, for each of a plurality of cells included in a battery module, selecting a cell having a maximum voltage difference among the plurality of cells as a representative cell, and estimating a state of charge (SOC) of the battery module by using a cell voltage of the representative cell.

The first time point may be a time point at which a direction of a current flow of the battery module is changed from a charging direction to a discharging direction.

The first time point may be, while a direction of a current flow of the battery module is sequentially changed from a charging direction via a no-current state to a discharging direction, a time point at which the direction of the current flow is changed from the charging direction to the no-current state.

The first time point may be, while a direction of a current flow of the battery module is sequentially changed from a charging direction via a no-current state to a discharging direction, a time point at which the direction of the current flow is changed from the no-current state to the discharging direction.

The second time point may be a time point at which a direction of a current flow of the battery module is changed from a discharging direction to a charging direction.

The second time point may be, while a direction of a current flow of the battery module is sequentially changed from a discharging direction via a no-current state to a charging direction, a time point at which the direction of the current flow is changed from the discharging direction to the no-current state.

The second time point may be, while a direction of a current flow of the battery module is sequentially changed from a discharging direction via a no-current state to a charging direction, a time point at which the direction of the current flow is changed from the no-current state to the charging direction.

An apparatus for determining a state of charge includes a detection device configured to detect a voltage of each of a plurality of cells included in a battery module, and a battery management system configured to calculate a voltage difference between a first voltage detected at a first time point and a second voltage detected at a second time point for each in the plurality of cells, to select a cell having a maximum voltage difference among the plurality of cells as a representative cell, and to estimate a state of charge (SOC) of the battery module by using a cell voltage of the representative cell.

The battery management system may be configured to determine a time point at which a direction of a current flow of the battery module is changed from a charging direction to a discharging direction as the first time point.

The battery management system may be configured to determine, while a direction of a current flow of the battery module is sequentially changed from a charging direction via a no-current state to a discharging direction, a time point at which the direction of the current flow is changed from the charging direction to the no-current state, or time point at which the direction of the current flow is changed from the no-current state to the discharging direction as the first time point.

The battery management system may be configured to determine a time point at which a direction of a current flow of the battery module is changed from a discharging direction to a charging direction as the second time point.

The battery management system may be configured to determine, while a direction of a current flow of the battery module is sequentially changed from a discharging direction via a no-current state to a charging direction, a time point at which the direction of the current flow is changed from the discharging direction to the no-current state, or time point at which the direction of the current flow is changed from the no-current state to the charging direction as the second time point.

A battery system including the apparatus for determining a state of charge having at least one of the above-mentioned features.

According to the present invention, the battery system may be protected from dangerous situations such as over-charge and over-discharge while decreasing the amount of calculation for calculating the SOC.

All embodiments described in this specification may be advantageously combined with one another to the extent that their respective features are compatible. In particular, the expressions "according to an embodiment," "in an embodiment," "an embodiment of the invention provides" etc. mean that the respective features may or may not be part of specific embodiments of the present invention.

### BRIEF DESCRIPTION OF THE DRAWINGS

FIG. 1 schematically illustrates a battery system according to an embodiment.
FIG. 2 is a drawing for showing a method for detecting an inflection point in a battery system according to an embodiment.
FIG. 3 shows a method for determining SOC in a battery system according to an embodiment.
FIG. 4 is a drawing for showing an effect of a method for determining SOC according to an embodiment.

### DETAILED DESCRIPTION OF THE EMBODIMENTS

Embodiments of the present invention will now be described in detail with accompanying drawings. Effects and characteristics of embodiments, and a realization method thereof will now be described in detail with accompanying drawings. In the drawings, same reference numerals indicate same constituent elements, and no repeated descriptions thereof will be provided. As those skilled in the art would realize, the described embodiments may be modified in various different ways, all without departing from the scope of the present invention. The embodiments are provided as examples so that the present disclosure may be thorough and complete, and will sufficiently supply aspects and characteristics of the present invention to a person skilled in the art.

Hence, for the purpose of complete understanding on the aspects and the characteristics of the present invention, processes, factors, and skills that may not be needed by a person of ordinary skill in the art may not be described. In the drawings, relative sizes of elements, layers, and regions may be exaggerated for clarity.

In the present specification, the term "and/or" includes all or random combinations of a plurality of items that are related and listed. When the embodiments of the present invention are described, the use of "can" or "may" signifies at least one embodiment of the present invention. Regarding the description on an embodiment of the present invention, a singular term may include a plural form unless stated in another way.

Terms including ordinal numbers such as "first", "second", and the like will be used only to describe various components, and are not to be interpreted as limiting these components. The terms are only used to differentiate one component from other components. For example, a first constituent element could be termed a second constituent element, and similarly, a second constituent element could be termed a first constituent element, without departing from the scope of the present invention.

It will be understood that when a constituent element or layer is referred to as being "on," "connected to," or "coupled to" another constituent element or layer, it can be directly on, connected to, or coupled to the other constituent element or layer, or one or more intervening constituent elements or layers may be present. In addition, it will also be understood that when a constituent element or layer is referred to as being "between" two constituent elements or layers, it can be the only constituent element or layer between the two constituent elements or layers, or one or more intervening constituent elements or layers may also be present.

Electrically connecting two constituent elements may include directly connecting two constituent elements, and connecting the same with another constituent element therebetween. Another constituent element may include a switch, a resistor, and a capacitor. When the embodiments are described, an expression of connection signifies electrical connection when an expression of direct connection is not provided.

Hereinafter, a method for determining a state of charge, a system for determining a state of charge performing the same, and a battery system according to an embodiment is described in detail with reference to the drawings.

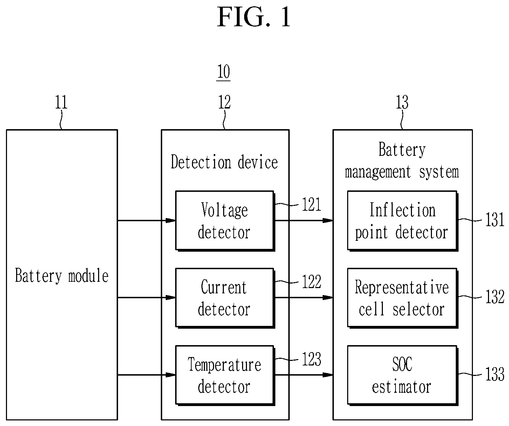

FIG. 1 schematically illustrates a battery system according to an embodiment.

Referring to FIG. 1, a battery system 10 according to an embodiment may include a battery module 11, a detection device 12, and battery management system (BMS) 13.

The battery module 11 may include a plurality of cells (not shown) that are interconnected in series.

The detection device 12 is configured to detect states of cells included in the battery module 11. The detection device 12 may include a voltage detector 121 configured to detect a cell voltage of each cell, a module voltage of the battery module 11, and the like. The detection device 12 may further include a current detector 122 configured to detect current flowing through the battery module 11. The detection device 12 may further include a temperature detector 123 configured to detect a temperature of the battery module 11 at at least one location.

A battery management system 13 may receive state information(voltage, current, temperature) of the battery module 11 from the detection device 12. The battery management system 13 may monitor a state (voltage, current, temperature, the state of charge (SOC), a state of health (SOH), and the like) of the battery module 11 based on state information received from the detection device 12. In addition, the battery management system 13 may perform a control function (for example, temperature control, cell balancing control, charge and discharge control, and the like), a protection function (for example, over-discharge, over-charge, overcurrent prevention, and the like), and the like, based on a state monitoring result.

According to this embodiment, the battery management system 13 may function as an apparatus for determining a state of charge of the battery module 11, together with the detection device 12. Based on state information detected through the detection device 12, the battery management system 13 may select one of the cells included in the battery module 11 as a representative cell, and estimate the SOC of the battery module 11 by using a cell voltage of the selected representative cell. For this purpose, the battery management system 13 may include an inflection point detector 131, the representative cell selector 132, and a SOC estimator 133.

The inflection point detector 131 may detect a time point at which the battery module 11 shifts between charge and discharge as an inflection point, based on a charging or discharging state of the battery module 11. For example, when a direction of a current flow of the battery module 11 is changed from charge direction to discharge direction via no-current, the inflection point detector 131 may detect a time point at which the direction of the current flow of the battery module 11 is changed from charge direction to no-current, or a time point at which the direction of the current flow of the battery module 11 is changed from no-current to discharge direction as the inflection point after charging. In addition, for example, when the direction of the current flow of the battery module 11 is changed from discharge direction to charge direction via no-current, the inflection point detector 131 may detect a time point at which the direction of the current flow of the battery module 11 is changed from discharge direction to no-current, or a time point at which the direction of the current flow of the battery module 11 is changed from no-current to charge direction as the inflection point after discharging. In addition, for example, it is also possible that the inflection point detector 131 may detect the time point at which the direction of the current flow of the battery module 11 is changed from charge direction to discharge direction as the inflection point after charging, or may detect the time point at which the direction of the current flow of the battery module 11 is changed from discharge direction to charge direction as the inflection point after discharging.

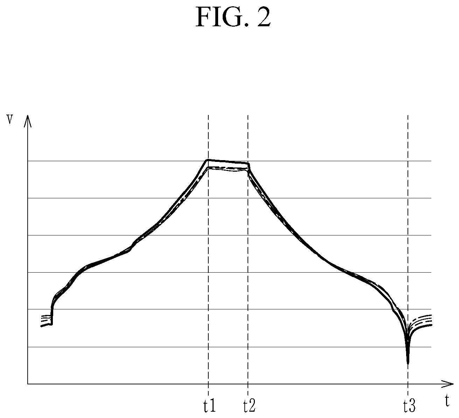

FIG. 2 is a drawing for explaining a method of detecting an inflection point in the inflection point detector 131 according to an embodiment, and illustrates voltage change trends of cells included in the battery module 11 as an example.

Referring to FIG. 2, the voltages of the cells included in the battery module 11 gradually increase by charging until a time point t1, and the charging of the battery module 11 is stopped from the time point t1 to a time point t2 (no-current state). Thereafter, the voltages of the cells included in the battery module 11 gradually decrease due to discharge from the time t2 to the time t3, and the charging of the battery module 11 starts again at the time t3. In this case, the inflection point detector 131 may determine the time point t1 at which the direction of the current state of the battery module 11 is changed from the charging direction to the no-current state, or the time point t2 at which the direction of the current state of the battery module 11 is changed from the no-current state to the discharging direction as the inflection point after charging, and may determine the time point t3 at which the direction of the current flow of the battery module 11 is changed from the discharging direction to the charging direction as the inflection point after discharging.

Referring back to FIG. 1, when the inflection points is detected by the inflection point detector 131, the representative cell selector 132 may calculate a voltage difference between cell voltages detected at consecutive inflection points, with respect to each cell. For example, the representative cell selector 132 may calculate, for each cell, a voltage difference between cell voltage detected at the inflection point after charging and a cell voltage detected at the inflection point after discharging afterwards. When the voltage difference between the inflection points is calculated for each cell, the representative cell selector 132 may select a cell having a largest voltage difference as the representative cell of the battery module 11. Cells may be charged and discharged faster than other cells as their capacity is smaller or their internal resistance is larger. Therefore, since a cell having a larger cell voltage difference between the inflection point after charging and the inflection point after discharging has a smaller capacity or a larger internal resistance, the cell with the largest voltage difference may be a cell with the smallest capacity or a cell with the largest resistance.

When the representative cell is selected among the battery module 11, the SOC estimator 133 may estimate the SOC of the battery module 11 by using current, temperature, and the like of the battery module 11 together with the cell voltage of the representative cell detected through the detection device 12.

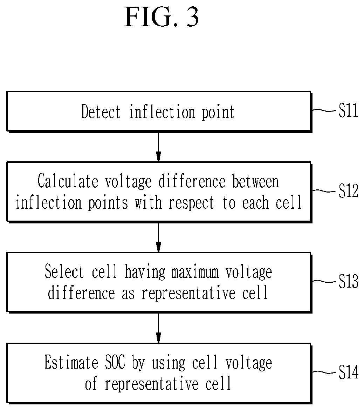

FIG. 3 shows a method for determining SOC in a battery system 10 according to an embodiment. The method of FIG. 3 may be performed by the battery management system described with reference to FIG. 1.

Referring to FIG. 3, at step S11, the battery management system 13 according to an embodiment may detect the inflection points that is a time point at which the battery module 11 shifts between charge and discharge, based on the charging and discharging state of the battery module 11. At the step S11, the battery management system 13 may detect the time point at which the direction of the current flow of the battery module 11 is changed from charge direction to discharge direction or the no-current state as the inflection point after charging. In addition, the battery management system 13 may detect the time point at which the direction of the current flow of the battery module 11 is changed from discharge direction to charge direction or the no-current state as the inflection point after discharging.

When the inflection points are detected through the step S11, the battery management system 13 may calculate the voltage difference between the inflection points with respect to each cell included in the battery module 11, at step S12. That is, the battery management system 13 may calculate, for each cell, a voltage difference between cell voltage detected at the inflection point after charging and a cell voltage detected at the inflection point after discharging afterwards.

When the voltage difference between the inflection points for each cell is calculated through the step S12, the battery management system 13 may select the cell having the largest calculated voltage difference among the cells included in the battery module 11 as the representative cell of the battery module 11, at step S13.

The representative cell is selected through the step S13, the battery management system 13 may estimate the SOC of the battery module 11 by using current, temperature, and the like of the battery module 11 together with the cell voltage of the representative cell, at step S14. Such estimated SOC may be considered as the SOC of all cells included in the battery module 11, and thereafter used in performing the control function, the protection function, and the like of the battery module 11.

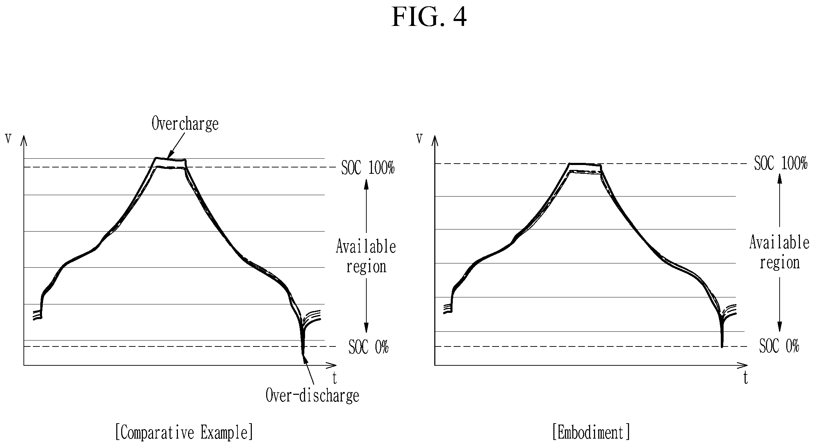

FIG. 4 is a drawing for showing an effect of a method for determining SOC according to an embodiment.

In FIG. 4, the diagram in Comparison example shows a voltage change trend obtained by estimating the SOC of the battery module 11 by using the average voltage of the cells included in the battery module 11, whereas the diagram in Embodiment section shows a voltage change trend obtained by estimating the SOC through the above-described method

Referring to FIG. 4, in the case of Comparison example, cells may be over-charged or over-discharged out of the available region of the actual cell. In comparison, in the case of using a method for determining SOC according to an embodiment, all cells included in the battery module 11 are charged and discharged within the available region.

As described above, a method for determining SOC according to an embodiment may protect the battery system 10 from dangerous situations such as over-charge and over-discharge while decreasing the amount of calculation for calculating the SOC.

Electronic or electrical devices according to embodiments of the present invention and/or other related devices or constituent elements may be realized by using appropriate hardware, firmware (e.g., an application-specific integrated circuit), software, or combinations of software, firmware, and hardware. For example, various configurations of the above-noted devices may be positioned on one integrated circuit (IC) chip or an individual IC chip. In addition, various configurations of the above-noted devices may be realized on a flexible printed circuit film, a tape carrier package (TCP), a printed circuit board (PCB), or one substrate. The electrical or mutual connections described in the present specification may, for example, be realized by the PCB, wires on different types of circuit carriers, or conductive elements. The conductive elements may, for example, include metallization such as surface metallizations and/or pins, and may include conductive polymers or ceramics.

In addition, the various configurations of the devices may be performed by at least one processor so as to perform the above-described various functions, they may be performed in at least one computing device, and they may be processes or threads for performing computer program instructions and interacting with other system constituent elements. The computer program instruction is stored in a memory realizable in a computing device using a standard memory device such as a random access memory (RAM). The computer program instruction may also be stored in a non-transitory computer readable medium such as a CD-ROM or a flash drive.

Further, a person of ordinary skill in the art must understand that various functions of the computing device may be combined or united to a single computing device, or functions of a specific computing device may be dispersed to at least another computing device while not digressing from the range of the embodiments of the present invention as defined by the claims.

It is clear for one of ordinary skill in the art that the disclosed embodiments can be combined where possible.

### <Description of symbols>

10: battery system
11: battery module
12: detection device
121: voltage detector
122: current detector
123: temperature detector
13: battery management system
131: inflection point detector
132: representative cell selector
133: SOC estimator

## Claims

1. A method for determining a state of charge of a battery system (10), the method comprising
calculating a voltage difference between a first voltage detected at a first time point and a second voltage detected at a second time point, for each of a plurality of cells included in a battery module (11);
selecting a cell having a maximum voltage difference among the plurality of cells as a representative cell; and
estimating a state of charge, SOC, of the battery module (11) by using a cell voltage of the representative cell.

2. The method of claim 1, wherein the first time point is a time point at which a direction of a current flow of the battery module (11) is changed from a charging direction to a discharging direction.

3. The method of claim 1, wherein the first time point is, while a direction of a current flow of the battery module (11) is sequentially changed from a charging direction via a no-current state to a discharging direction, a time point at which the direction of the current flow is changed from the charging direction to the no-current state.

4. The method of claim 1, wherein the first time point is, while a direction of a current flow of the battery module (11) is sequentially changed from a charging direction via a no-current state to a discharging direction, a time point at which the direction of the current flow is changed from the no-current state to the discharging direction.

5. The method of any one of claims 1 to 4, wherein the second time point is a time point at which a direction of a current flow of the battery module (11) is changed from a discharging direction to a charging direction.

6. The method of any one of claims 1 to 4, wherein the second time point is, while a direction of a current flow of the battery module (11) is sequentially changed from a discharging direction via a no-current state to a charging direction, a time point at which the direction of the current flow is changed from the discharging direction to the no-current state.

7. The method of any one of claims 1 to 4, wherein the second time point is, while a direction of a current flow of the battery module (11) is sequentially changed from a discharging direction via a no-current state to a charging direction, a time point at which the direction of the current flow is changed from the no-current state to the charging direction.

8. An apparatus for determining a state of charge, the apparatus comprising:
a detection device (12) configured to detect a voltage of each of a plurality of cells included in a battery module (11); and
a battery management system (13) configured to calculate a voltage difference between a first voltage detected at a first time point and a second voltage detected at a second time point for each in the plurality of cells, to select a cell having a maximum voltage difference among the plurality of cells as a representative cell, and to estimate a state of charge, SOC, of the battery module (11) by using a cell voltage of the representative cell.

9. The apparatus of claim 8, wherein the battery management system (13) is configured to determine a time point at which a direction of a current flow of the battery module (11) is changed from a charging direction to a discharging direction as the first time point.

10. The apparatus of claim 8, wherein the battery management system (13) is configured to determine, while a direction of a current flow of the battery module (11) is sequentially changed from a charging direction via a no-current state to a discharging direction, a time point at which the direction of the current flow is changed from the charging direction to the no-current state as the first time point.

11. The apparatus of claim 8, wherein the battery management system (13) is configured to determine, while a direction of a current flow of the battery module (11) is sequentially changed from a charging direction via a no-current state to a discharging direction, a time point at which the direction of the current flow is changed from the no-current state to the discharging direction as the first time point.

12. The apparatus of any one of claims 8 to 11, wherein the battery management system (13) is configured to determine a time point at which a direction of a current flow of the battery module (11) is changed from a discharging direction to a charging direction as the second time point.

13. The apparatus of any one of claims 8 to 11, wherein the battery management system (13) is configured to determine, while a direction of a current flow of the battery module (11) is sequentially changed from a discharging direction via a no-current state to a charging direction, a time point at which the direction of the current flow is changed from the discharging direction to the no-current state as the second time point.

14. The apparatus of any one of claims 8 to 11, wherein the battery management system (13) is configured to determine, while a direction of a current flow of the battery module (11) is sequentially changed from a discharging direction via a no-current state to a charging direction, a time point at which the direction of the current flow is changed from the no-current state to the charging direction as the second time point.

15. A battery system (10) comprising the apparatus for determining a state of charge according to any one of claim 8 to claim 14.

## Patentansprüche

1. Verfahren zur Bestimmung eines Ladezustands eines Batteriesystems (10), wobei das Verfahren umfasst
Berechnen einer Spannungsdifferenz zwischen einer ersten Spannung, die zu einem ersten Zeitpunkt erfasst wird, und einer zweiten Spannung, die zu einem zweiten Zeitpunkt erfasst wird, für jede einer Mehrzahl von Zellen, die in einem Batteriemodul (11) enthalten sind;
Auswählen einer Zelle mit einer maximalen Spannungsdifferenz unter der Mehrzahl von Zellen als repräsentative Zelle; und
Schätzen eines Ladezustands, *state of charge -* SOC, des Batteriemoduls (11) unter Verwendung einer Zellenspannung der repräsentativen Zelle.

2. Verfahren nach Anspruch 1, wobei der erste Zeitpunkt ein Zeitpunkt ist, zu dem eine Richtung eines Stromflusses des Batteriemoduls (11) von einer Ladungsrichtung in eine Entladungsrichtung geändert wird.

3. Verfahren nach Anspruch 1, wobei der erste Zeitpunkt, wenn eine Richtung eines Stromflusses des Batteriemoduls (11) sequenziell von einer Ladungsrichtung über einen stromlosen Zustand in eine Entladungsrichtung geändert wird, ein Zeitpunkt ist, zu dem die Richtung des Stromflusses von der Ladungsrichtung in den stromlosen Zustand geändert wird.

4. Verfahren nach Anspruch 1, wobei der erste Zeitpunkt, wenn eine Richtung eines Stromflusses des Batteriemoduls (11) sequenziell von einer Ladungsrichtung über einen stromlosen Zustand in eine Entladungsrichtung geändert wird, ein Zeitpunkt ist, zu dem die Richtung des Stromflusses vom stromlosen Zustand in die Entladungsrichtung geändert wird.

5. Verfahren nach einem der Ansprüche 1 bis 4, wobei der zweite Zeitpunkt ein Zeitpunkt ist, zu dem eine Richtung eines Stromflusses des Batteriemoduls (11) von einer Entladungsrichtung in eine Ladungsrichtung geändert wird.

6. Verfahren nach einem der Ansprüche 1 bis 4, wobei der zweite Zeitpunkt, wenn eine Richtung eines Stromflusses des Batteriemoduls (11) sequenziell von einer Entladungsrichtung über einen stromlosen Zustand in eine Ladungsrichtung geändert wird, ein Zeitpunkt ist, zu dem die Richtung des Stromflusses von der Entladungsrichtung in den stromlosen Zustand geändert wird.

7. Verfahren nach einem der Ansprüche 1 bis 4, wobei der zweite Zeitpunkt, wenn eine Richtung eines Stromflusses des Batteriemoduls (11) sequenziell von einer Entladungsrichtung über einen stromlosen Zustand in eine Ladungsrichtung geändert wird, ein Zeitpunkt ist, zu dem die Richtung des Stromflusses vom stromlosen Zustand in die Ladungsrichtung geändert wird.

8. Gerät zur Bestimmung eines Ladezustands, wobei das Gerät umfasst:
eine Erfassungsvorrichtung (12), die dazu ausgestaltet ist, eine Spannung jeder einer Mehrzahl von Zellen zu erfassen, die in einem Batteriemodul (11) enthalten sind; und
ein Batteriemanagementsystem (13), das dazu ausgestaltet ist, eine Spannungsdifferenz zwischen einer ersten Spannung, die zu einem ersten Zeitpunkt erfasst wird, und einer zweiten Spannung, die zu einem zweiten Zeitpunkt erfasst wird, für jede der Mehrzahl von Zellen zu berechnen, eine Zelle mit einer maximalen Spannungsdifferenz unter der Mehrzahl von Zellen als repräsentative Zelle auszuwählen und einen Ladezustand, *state of charge -* SOC, des Batteriemoduls (11) unter Verwendung einer Zellenspannung der repräsentativen Zelle zu schätzen.

9. Gerät nach Anspruch 8, wobei das Batteriemanagementsystem (13) dazu ausgestaltet ist, einen Zeitpunkt, zu dem eine Richtung eines Stromflusses des Batteriemoduls (11) von einer Ladungsrichtung in eine Entladungsrichtung geändert wird, als ersten Zeitpunkt zu bestimmen.

10. Gerät nach Anspruch 8, wobei das Batteriemanagementsystem (13) dazu ausgestaltet ist, wenn eine Richtung eines Stromflusses des Batteriemoduls (11) sequenziell von einer Ladungsrichtung über einen stromlosen Zustand in eine Entladungsrichtung geändert wird, einen Zeitpunkt, zu dem die Richtung des Stromflusses von der Ladungsrichtung in den stromlosen Zustand geändert wird, als ersten Zeitpunkt zu bestimmen.

11. Gerät nach Anspruch 8, wobei das Batteriemanagementsystem (13) dazu ausgestaltet ist, wenn eine Richtung eines Stromflusses des Batteriemoduls (11) sequenziell von einer Ladungsrichtung über einen stromlosen Zustand in eine Entladungsrichtung geändert wird, einen Zeitpunkt, zu dem die Richtung des Stromflusses vom stromlosen Zustand in die Entladungsrichtung geändert wird, als ersten Zeitpunkt zu bestimmen.

12. Gerät nach einem der Ansprüche 8 bis 11, wobei das Batteriemanagementsystem (13) dazu ausgestaltet ist, einen Zeitpunkt, zu dem eine Richtung eines Stromflusses des Batteriemoduls (11) von einer Entladungsrichtung in eine Ladungsrichtung geändert wird, als zweiten Zeitpunkt zu bestimmen.

13. Gerät nach einem der Ansprüche 8 bis 11, wobei das Batteriemanagementsystem (13) dazu ausgestaltet ist, wenn eine Richtung eines Stromflusses des Batteriemoduls (11) sequenziell von einer Entladungsrichtung über einen stromlosen Zustand in eine Ladungsrichtung geändert wird, einen Zeitpunkt, zu dem die Richtung des Stromflusses von der Entladungsrichtung in den stromlosen Zustand geändert wird, als zweiten Zeitpunkt zu bestimmen.

14. Gerät nach einem der Ansprüche 8 bis 11, wobei das Batteriemanagementsystem (13) dazu ausgestaltet ist, wenn eine Richtung eines Stromflusses des Batteriemoduls (11) sequenziell von einer Entladungsrichtung über einen stromlosen Zustand in eine Ladungsrichtung geändert wird, einen Zeitpunkt, zu dem die Richtung des Stromflusses vom stromlosen Zustand in die Ladungsrichtung geändert wird, als zweiten Zeitpunkt zu bestimmen.

15. Batteriesystem (10), umfassend das Gerät zur Bestimmung eines Ladezustands nach einem der Ansprüche 8 bis 14.

## Revendications

1. Procédé de détermination d'un état de charge d'un système de batterie (10), le procédé comportant
le calcul d'une différence de tension entre une première tension détectée à un premier instant et une deuxième tension détectée à un deuxième instant, pour chacune d'une pluralité de cellules incluses dans un module de batterie (11) ;
la sélection d'une cellule ayant une différence de tension maximale parmi la pluralité de cellules en tant que cellule représentative ; et
l'estimation d'un état de charge, SOC, du module de batterie (11) à l'aide d'une tension de cellule de la cellule représentative.

2. Procédé selon la revendication 1, dans lequel le premier instant est un instant auquel une direction d'un flux de courant du module de batterie (11) passe d'une direction de charge à une direction de décharge.

3. Procédé selon la revendication 1, dans lequel le premier instant est, tandis qu'une direction d'un flux de courant du module de batterie (11) passe séquentiellement d'une direction de charge via un état sans courant à une direction de décharge, un instant auquel la direction du flux de courant passe de la direction de charge à l'état sans courant.

4. Procédé selon la revendication 1, dans lequel le premier instant est, tandis qu'une direction d'un flux de courant du module de batterie (11) passe séquentiellement d'une direction de charge via un état sans courant à une direction de décharge, un instant auquel la direction du flux de courant passe de l'état sans courant à la direction de décharge.

5. Procédé selon l'une quelconque des revendications 1 à 4, dans lequel le deuxième instant est un instant auquel une direction d'un flux de courant du module de batterie (11) passe d'une direction de décharge à une direction de charge.

6. Procédé selon l'une quelconque des revendications 1 à 4, dans lequel le deuxième instant est, tandis qu'une direction d'un flux de courant du module de batterie (11) passe séquentiellement d'une direction de décharge via un état sans courant à une direction de charge, un instant auquel la direction du flux de courant passe de la direction de décharge à l'état sans courant.

7. Procédé selon l'une quelconque des revendications 1 à 4, dans lequel le deuxième instant est, tandis qu'une direction d'un flux de courant du module de batterie (11) passe séquentiellement d'une direction de décharge via un état sans courant à une direction de charge, un instant auquel la direction du flux de courant passe de l'état sans courant à la direction de charge.

8. Appareil de détermination d'un état de charge, l'appareil comportant :
un dispositif de détection (12) configuré pour détecter une tension de chacune d'une pluralité de cellules incluses dans un module de batterie (11) ; et
un système de gestion de batterie (13) configuré pour calculer une différence de tension entre une première tension détectée à un premier instant et une deuxième tension détectée à un deuxième instant pour chacune de la pluralité de cellules, pour sélectionner une cellule ayant une différence de tension maximale parmi la pluralité de cellules en tant que cellule représentative, et pour estimer un état de charge, SOC, du module de batterie (11) à l'aide d'une tension de cellule de la cellule représentative.

9. Appareil selon la revendication 8, dans lequel le système de gestion de batterie (13) est configuré pour déterminer un instant auquel une direction d'un flux de courant du module de batterie (11) passe d'une direction de charge à une direction de décharge en tant que premier instant.

10. Appareil selon la revendication 8, dans lequel le système de gestion de batterie (13) est configuré pour déterminer, tandis qu'une direction d'un flux de courant du module de batterie (11) passe séquentiellement d'une direction de charge via un état sans courant à une direction de décharge, un instant auquel la direction du flux de courant passe de la direction de charge à l'état sans courant en tant que premier instant.

11. Appareil selon la revendication 8, dans lequel le système de gestion de batterie (13) est configuré pour déterminer, tandis qu'une direction d'un flux de courant du module de batterie (11) passe séquentiellement d'une direction de charge via un état sans courant à une direction de décharge, un instant auquel la direction du flux de courant passe de l'état sans courant à la direction de décharge en tant que premier instant.

12. Appareil selon l'une quelconque des revendications 8 à 11, dans lequel le système de gestion de batterie (13) est configuré pour déterminer un instant auquel une direction d'un flux de courant du module de batterie (11) passe d'une direction de décharge à une direction de charge en tant que deuxième instant.

13. Appareil selon l'une quelconque des revendications 8 à 11, dans lequel le système de gestion de batterie (13) est configuré pour déterminer, tandis qu'une direction d'un flux de courant du module de batterie (11) passe séquentiellement d'une direction de décharge via un état sans courant à une direction de charge, un instant auquel la direction du flux de courant passe de la direction de décharge à l'état sans courant en tant que deuxième instant.

14. Appareil selon l'une quelconque des revendications 8 à 11, dans lequel le système de gestion de batterie (13) est configuré pour déterminer, tandis qu'une direction d'un flux de courant du module de batterie (11) passe séquentiellement d'une direction de décharge via un état sans courant à une direction de charge, un instant auquel la direction du flux de courant passe de l'état sans courant à la direction de charge en tant que deuxième instant.

15. Système de batterie (10) comportant l'appareil de détermination d'un état de charge selon l'une quelconque des revendications 8 à 14.
